# EUROPEAN PATENT APPLICATION

(11) **EP 4 786 999 A1**
(43) Date of publication of application: **05.08.2026**
(21) Application number: 25223596.5
(22) Date of filing: 15.12.2025
(51) Int. Cl.: G01R 31/52

(54) **CONCENTRATOR FOR A LEAKAGE CURRENT SENSOR**

(30) Priority: 29.01.2025 US 202519039852
(71) Applicant: Allegro MicroSystems, LLC, Manchester, NH 03103 (US)
(72) Inventor: SHEWMON, Nathan, 38114 Braunschweig (DE); GILLET, Cédric, 74000 Annecy (FR); AERABI, Ehsan, 38700 La Tronche (FR)
(74) Representative: South, Nicholas Geoffrey

(57) **Abstract**

According to one aspect, a magnetic flux concentrator includes: a ferromagnetic material having a loop shape interrupted by an air gap region and forming a central opening, wherein the air gap region includes a first side having at least two protrusions and a second side having at least one protrusion interleaved with, and not in mechanical contact with, the protrusions of the first side. According to another aspect, a sensor utilizes such a magnetic flux concentrator to detect a difference in current between two conductors.

## Description

### BACKGROUND

A leakage current sensor works by detecting the difference between current flowing into and out of a circuit. For example, a leakage current sensor can detect a difference between current in a first conductor (e.g., a conductive path from a power source to a load) and current in a second conductor (e.g., a return path from the load to the power source). Under normal circumstances, these two currents should be equal. A difference in current can indicate an abnormal diversion of current in the circuit, such as a short caused by an exposed wire touches a metal housing. In such a case, the leakage current sensor can, for example, report the detected short to a control system, which can then take protective action, for example by disconnecting the source of the current. One type of leakage current sensor is the ground fault interrupter (GFI).

### SUMMARY

In the case where the two conductors (e.g., wires) are nearby and parallel to each other, and carrying current in opposite directions, the magnetic fields generated by two nearby conductors substantially cancel out. If a short occurs in the circuit, then some of the return current flows through a different path, and the two opposite currents, no longer being equal, generate a detectable magnetic field. Thus, a leakage current sensor can operate using magnetic field detection.

A magnetic-field-based leakage current sensor can include one or more magnetic field sensing elements, and associated circuitry, configured to measure the magnetic field generated by two nearby conductors carrying current in opposite directions. Such a sensor can utilize a magnetic flux concentrator ("concentrator" for short) configured to focus magnetic flux lines, generated by the two nearby conductors, at the center of an air gap where the magnetic field sensing elements are located.

Described herein are general structures and techniques for providing improved concentrators for use with leakage current sensors, as well as for providing improved leakage current sensors and improved devices and systems within which leakage current sensors are employed.

According to one aspect of the present disclosure, a magnetic flux concentrator includes a ferromagnetic material having a loop shape interrupted by an air gap region and forming a central opening, wherein the air gap region includes a first side having at least two protrusions and a second side having at least one protrusion interleaved with, and not in mechanical contact with, the protrusions of the first side.

In some embodiments, the loop shape lies within a plane, wherein in response to a difference in current between two conductors positioned within the central opening, the concentrator generates a differential magnetic field within the plane. In some embodiments, in response to the difference in current between the two conductors positioned within the central opening, the concentrator generates a substantially symmetrical field along an axis perpendicular to the plane.

In some embodiments, the protrusions on the first side of the air gap region and the protrusion of the second side of the air gap region extend along a common axis. In some embodiments, the air gap region includes at least: a first air gap extending along the common axis from the first side of the air gap region to the protrusion of the second side of the air gap region; a second air gap extending along an axis perpendicular to the common axis from a first one of the protrusions of the first side of the air gap region and the protrusion of the second side of the air gap region; and a third air gap extending along the perpendicular axis from a second one of the protrusions of the first side of the air gap region and the protrusion of the second side of the air gap region. In some embodiments, the first air gap has a length (Xgap) and the second and third air gaps both have a length (Ygap), wherein Xgap is substantially greater than Ygap. In some embodiments, the second and third air gaps both have a length (Ygap) in a range of 0.2mm to 2mm. In some embodiments, the second-side protrusion extends along the common axis into a U-shaped opening formed by the first-side protrusions by a distance (X1+X3) in a range of 0.5mm to 2.0mm.

In some embodiments, the magnetic flux concentrator has a tapered loop shape. In some embodiments, the loop shape is substantially an annulus.

According to another aspect of the present disclosure, a system includes: first and second magnetic field sensing elements both supported by a substrate and both having an axis of maximum sensitivity parallel to the substrate; and a magnetic flux concentrator having an air gap region comprising at least a first air gap positioned above or below the first magnetic field sensing element and a second air gap positioned above or below the second magnetic field sensing element, the magnetic flux concentrator configured to generate a differential magnetic field about the first and second magnetic field sensing elements and parallel to the substrate.

In some embodiments, the magnetic flux concentrator has a loop shape interrupted by the air gap region and forming a central opening. In some embodiments, the differential magnetic field is generated in response to a difference in current between two conductors positioned within the central opening.

In some embodiments, the system can further include circuitry configured to: receive a first sensing signal generated by the first magnetic field sensing element; receive a second sensing signal generated by the second magnetic field sensing element; and detect the difference in current using the first and second sensing signals. In some embodiments, the circuitry includes at least one of: a first swapping to change a polarity of the first sensing signal; and a second swapping to change a polarity of the second sensing signal. In some embodiments, the circuitry includes: an element to generate a combined sensing signal as a sum or a difference of the first and second sensing signals; and a comparator to detect the difference in current using the combined sensing signal.

In some embodiments, the first and second magnetic field sensing elements both include four tunneling magnetoresistance (TMR) elements arranged in a full bridge. In some embodiments, the substrate is provided within an integrated circuit (IC) package affixed to a surface of a printed circuit board (PCB), wherein the magnetic flux concentrator is arranged parallel to the surface of the PCB. In some embodiments, the magnetic flux concentrator is at least partially encased in a housing affixed to the PCB.

It should be appreciated that individual elements of different embodiments described herein may be combined to form other embodiments not specifically set forth above. Various elements, which are described in the context of a single embodiment, may also be provided separately or in any suitable sub-combination. It should also be appreciated that other embodiments not specifically described herein are also within the scope of the following claims.

### BRIEF DESCRIPTION OF THE DRAWINGS

The manner of making and using the disclosed subject matter may be appreciated by reference to the detailed description in connection with the drawings, in which like reference numerals identify like elements.
Fig. 1 is top view of a concentrator for use with a leakage current sensor, according to some embodiments of the present disclosure.
Fig. 1A is a close-up view of Fig. 1 showing an air gap region of the concentrator.
Fig. 1B is another close-up view of Fig. 1 illustrating air gap design parameters.
Fig. 2 is a perspective view of a leakage current sensor and concentrator assembly, according to some embodiments.
Fig. 2A is a top view of a portion of the assembly of Fig. 2.
Fig. 2B is a side view of a portion of the assembly of Fig. 2.
Fig. 2C is another side view of a portion of the assembly of Fig. 2.
Fig. 3 is a schematic diagram of a leakage current sensor circuit, according to some embodiments.
Fig. 4 is a graphical diagram illustrating how air gap design parameters in Fig. 1B can be varied to achieve a desired coupling factor.

The drawings are not necessarily to scale, or inclusive of all elements of a system, emphasis instead generally being placed upon illustrating the concepts, structures, and techniques sought to be protected herein.

### DETAILED DESCRIPTION

As used herein, the term "magnetic field sensing element" is used to describe a variety of electronic elements that can sense a magnetic field. A magnetic field sensing element can be, but is not limited to, a Hall Effect element, a magnetoresistance element, a magnetotransistor or an inductive coil. There are several types of Hall Effect elements, for example, a planar Hall element, a vertical Hall element, and a Circular Vertical Hall (CVH) element. There are several types of magnetoresistance (MR) elements, for example, a semiconductor magnetoresistance element such as Indium Antimonide (InSb), a giant magnetoresistance (GMR) element, an anisotropic magnetoresistance element (AMR), a tunneling magnetoresistance (TMR) element, and a magnetic tunnel junction (MTJ).

A magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb).

Some of the above-described magnetic field sensing elements tend to have an axis of maximum sensitivity parallel to a substrate that supports the magnetic field sensing element, and others of the above-described magnetic field sensing elements tend to have an axis of maximum sensitivity perpendicular to a substrate that supports the magnetic field sensing element. These two different types of sensing elements are sometimes referred to as "in-plane" and "out-of-plane" sensing elements. In particular, planar Hall elements tend to have axes of sensitivity perpendicular to a substrate, while metal based or metallic MR elements (e.g., GMR, TMR, AMR) and vertical Hall elements tend to have axes of sensitivity parallel to a substrate.

As used herein, the term "magnetic-field-based sensor" refers to an assembly having one or more magnetic field sensing elements and electronic circuitry, all disposed upon a common substrate, e.g., a semiconductor substrate. The term "magnetic-field-based leakage current sensor" is used to describe such an assembly particularly configured to detect current leakage. Such a sensor may be fabricated on a die and packaged as a chip, for example. In some examples, such as sensor may include two or more magnetic field sensing elements.

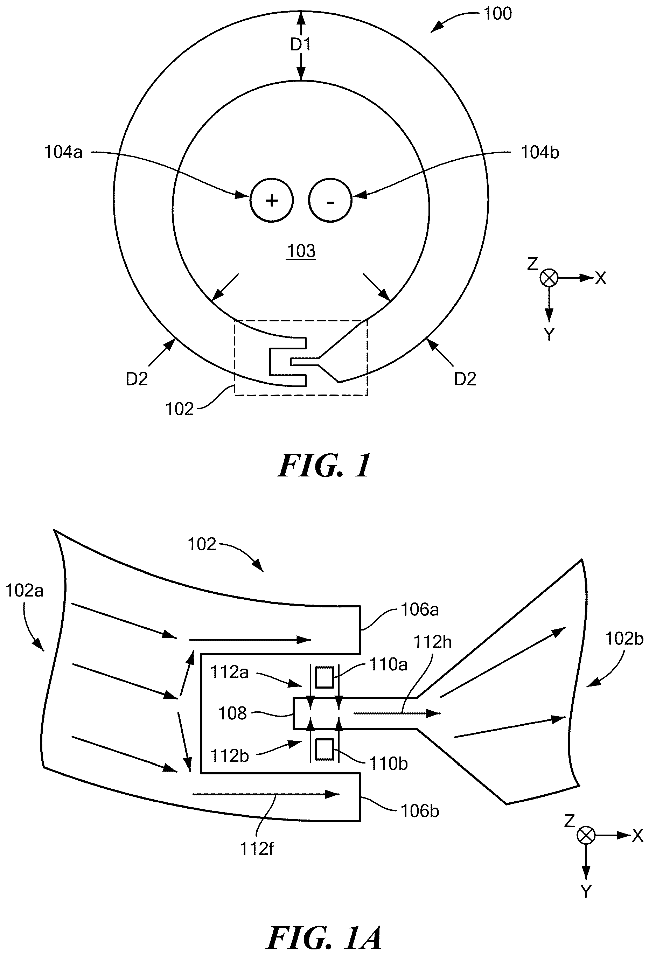

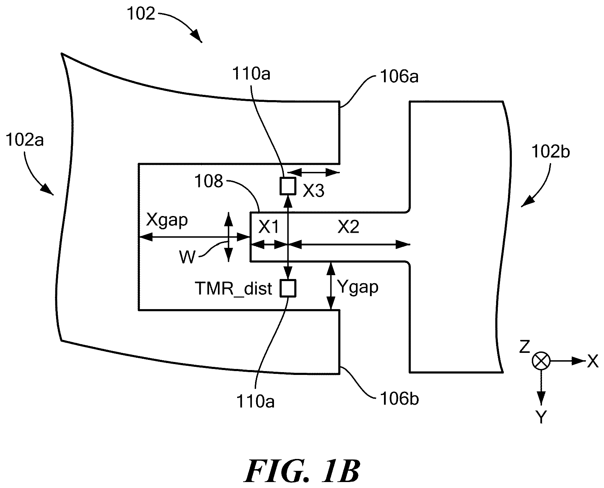

Turning to Figs. 1 and 1A, it is appreciated herein that it may be desirable to use MR elements, and TMR elements in particular, for leakage current sensing as MR sensing technology has can achieve significantly higher performance (e.g., sensitivity) compared to other technologies. Thus, it would be advantageous to design a magnetic flux concentrator that generates a field for in-plane sensing and, in some cases, for differential in-plan sensing.

Fig. 1 shows an example of a concentrator 100 designed to generate a field for in-plane differential sensing. Illustrate concentrator 100 has a loop shape interrupted by an air gap region 102 and forming a central opening 103. Concentrator 100 may comprise a ferromagnetic material such as steel, Ferrite, a nickel-iron alloy (NiFe), a silicon-iron alloy (SiFe), or other soft ferromagnetic material.

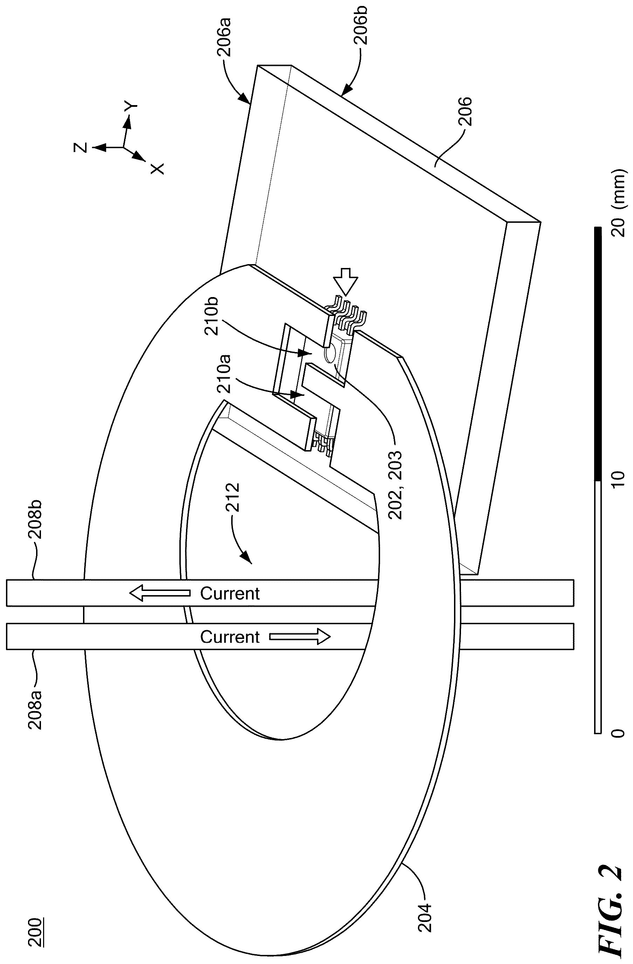

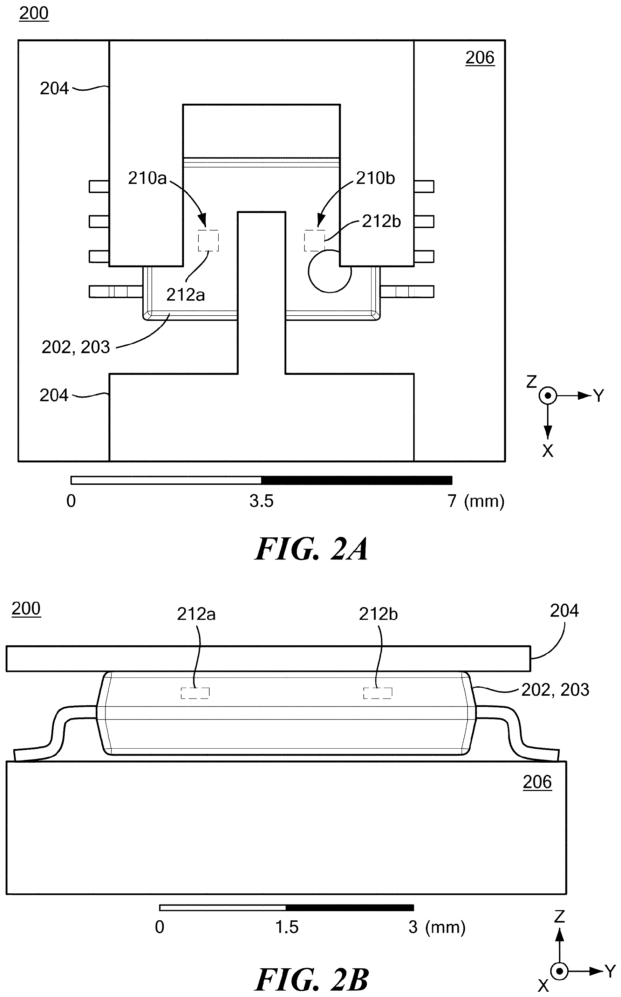

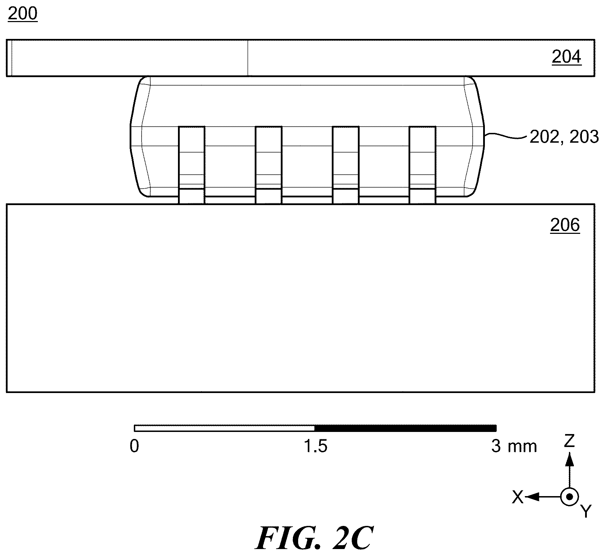

In the example of Fig. 1, the concentrator has a generally annular shape, that is a shape generally defined by two concentric circles of different radii lying with a plane (e.g., X-Y plane) and a thickness along the perpendicular axis (e.g., Z axis). The concentrator thickness is not visible in Fig. 1 but should be understood to be significantly smaller than an outer dimension of the planar shape (e.g., significantly smaller than the radius of the outer concentric circle, in the case of an annulus). According to the general concepts, designs, and structures sought to be protected herein, a concentrator can have various other planar shapes that form a loop (notwithstanding the air gap). For example, a concentrator can have a shape approximated by two concentric rectangles or other types of convex polygons. As another example, a concentrator can have a generally annulus shape except around the air gap where the shape can be substantially rectangular, such as illustrated in Fig. 2.

Two conductors 104a,b can be positioned within central opening 103 of the concentrator. In the view of Fig. 1, a first conductor 104a can carry current into a circuit (not shown) and a second conductor 104 can carry current out of the circuit. For example, first conductor 104a can carry current from a power source to a load and second conductor 104 can serve as a return path, carrying current from the load to the power source. Conductors 104a,b can extend along the Z axis in Fig. 1 (i.e., perpendicular to the drawing sheet).

As shown, the loop-shaped concentrator 100 can be tapered in some embodiments. For example, concentrator 100 can have a maximum width D1 at a position approximately 180° from the air gap (in the X-Y plane), and a smaller width D1 < D2 at positions < 180° from the air gap. More generally, according to the present disclosure, a concentrator can have different widths at different points along its loop. In some embodiments, a concentrator can have a substantially uniform thickness (Z axis) along its loop.

Turning to Fig. 1A, air gap region 102 of concentrator 100 can have a first side 102a and a second side 102b, not in mechanical contact with each other (e.g., seperated by gaps along both the X and Y axes). First side 102a can be shaped to have at least one pair of protrusions 106a,b (or "fingers") both extending in the same direction along a common axis (+X direction), parallel to each other, and spaced apart to form a U-shaped opening. Second side 102b can be shaped to have at least one protrusion 108 extending along the same axis but in the opposite direction (-X direction) and at least partially into U-shaped opening formed by first-side protrusions 106a,b. In other words, the second-side protrusion 108 may be interleaved with the first-side protrusions 106a,b.

While the example of Fig. 1A has one set of first-side protrusions 106a,b and a single second-side protrusion 108, other numbers of these elements may be used. For example, second-side 102b may include two protrusions that are interleaved with three protrusions provided on first side 102a. As another example, second-side 102b may include three protrusions that are interleaved with four protrusions provided on first side 102a.

As shown, second-side protrusion 108 can have a width (along the Y axis) that is less than a width (also along the Y axis) of the U-shaped opening, thus forming air gaps 112a,b within which a pair of magnetic field sensing elements 110a,b can be respectively positioned. While, as a matter of convenience, the two sensing elements 110a,b are described being positioned within separate air gaps 112a,b, it should be appreciated that these are actually part of a single air gap that interrupts the loop-shaped concentrator. In some embodiments, sensing elements 110a,b may be positioned just above or just below respective air gaps 112a,b. In more detail, a first sensing element 110a can be positioned on one side of second-side protrusion 108 and a second sensing element 110b can be positioned on the opposite side of second-side protrusion 108 (along the Y axis). Sensing elements 110a,b may be located on a sensor die (not shown in Fig. 1A) that sits just above or below the concentrator 100. Since the concentrator design is symmetrical on Z axis, its effect is the same on sensing elements positioned above or beneath.

In some embodiments, sensing elements 110a,b can be provided as TMR elements. In some embodiments, both sensing elements 110a,b can be provided as multiple TMR elements arranged in a half bridge or full bridge topology.

Sensing elements 110a,b may be configured to sense magnetic field in opposite directions. For example, first sensing element 110a may be configured to sense a magnetic field in the +Y direction and second sensing element 110b may be configured to sense a magnetic field in the -Y direction. Magnetic flux generated by current through conductors 104a,b (e.g., when there is a current difference between the two conductors 104a,b) can be concentrated in the plane (X-Y plane) of loop-shaped concentrator 100. In Fig. 1A, possible magnetic field lines are illustrated by arrows that generally run from left to right (in +X direction) except in the air gaps 112a,b where sensing elements 110a,b are respectively positioned. In those positions, owing to the interleaved finger design, the field lines run in opposite perpendicular directions, specifically in the +Y direction across the plane of sensing element 110a and in the -Y direction across the plane of sensing element 110b. The two opposite perpendicular fields may be referred to as a differential planar field, meaning a field in the same plane as the two sensing elements, but with opposite directions across the two sensing elements. Thus, the illustrated concentrator 100 is designed for in-plane differential sensing.

Of note, Fig. 1A shows a condition where there is a difference between currents in the two conductors. If the currents are equal, there would be no flux and thus the arrows showing magnetic field lines in the concentrator would be omitted. Also, the direction of concentrator field lines around the concentrator's loop, and within the air gap region, depends on whether the current difference is positive or negative. Thus, for example, field lines may run in generally opposite directions from those depicted in Fig. 1A.

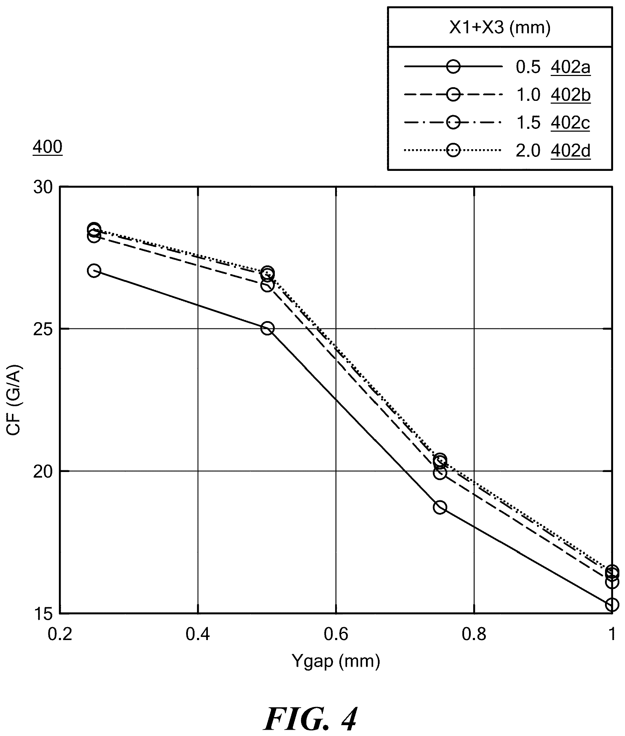

Fig. 1B illustrates design parameters of the air gap region 102 of concentrator 100. As shown, the two sides 102a,b can be gapped by a distance Xgap in along the X axis, and by a distance Ygap along the Y axis. In some embodiments, Xgap may be greater than Ygap. In some embodiments, Xgap may be substantially greater than Ygap. Second-side protrusion 108 can have a length X1+X2 along the X axis and a width W along the Y axis. First-side protrusions 106a,b can have a length Xgap+X1+X3 along the X axis, and be spaced apart by a distance (2×Ygap)+W along the Y axis. Thus, as can be seen, second-side protrusion 108 can extend into the U-shaped formed by first-side protrusion 106a,b by a distance X1+X3. Sensing elements 110a,b can be offset by a distance X1 from an end of second-side protrusion 108 in the +X direction and spaced apart by a distance TMR_dist along the Y axis. These various air gap design parameters can by varied to achieve a desired concentrator coupling factor (how much field is generated at the sensing elements for a given sensed current difference), as discussed further below in the context of Fig. 4.

The concentrator design illustrated in Figs. 1 and 1A may be referred to as a planar-field concentrator because it applies a predominately planar field on sensing elements 110a,b in response to a current difference through conductors 104a,b. More particularly, the concentrator design may be referred to as an in-plane differential sensing concentrator. It is appreciated herein that a planar-field concentrator can achieve a coupling factor that is equal to or greater than that achieved with a perpendicular-field concentrator.

Fig. 2 shows an assembly 200 of a leakage current sensor 202 and a magnetic flux concentrator 204, according to some embodiments. Concentrator 204 may be designed similar to concentrator 100 of Figs. 1 and 1A. As shown, sensor 202 may be embodied within an integrated circuit (IC) package 203 (e.g., a 6-lead package) that is affixed (e.g., soldered) to a top surface 206a of a printed circuit board (PCB) 206. Concentrator 204 can be arranged parallel to the PCB surface 206a (e.g., both in the X-Y plane) and with air gaps 210a,b positioned above magnetic field sensing elements (e.g., TMR elements, not shown) of sensor 202. In other examples, air gaps 210a,b can be positioned below the sensing elements. A pair of conductors 208a,b may be positioned within a central opening 212 of concentrator 204 and extend generally perpendicular (Z axis) to the plane of concentrator 204.

In some embodiments, concentrator 204 may be at least partially encased in a housing (e.g., a plastic housing, not shown) that is affixed to PCB 206. For example, concentrator 204 may be disposed between two pieces of plastic that are fastened together to clamp onto top and bottom PCB surfaces 206a,b at an edge of the PCB 206 proximate to sensor 202. In some embodiments, the housing may be designed such that concentrator air gaps 210a,b are left exposed while other portions of concentrator 210 are encased. In some embodiments, a circular opening, corresponding to central opening 212, may be formed within the housing to allow for passage of conductors 208a,b. The position and radius of the circular opening may be selected such that conductors 208a,b are sufficiently distanced from sensor 202 to prevent direct coupling of the conductors 208a,b thereto.

Fig. 2A is a top view showing a portion of the leakage current sensor and a magnetic flux concentrator assembly 200 of Fig. 2. As shown, magnetic field sensing elements 212a,b, located within sensor IC package 203, can be positioned below concentrator air gaps 210a,b respectively. In other examples, sensing elements 212a,b may be positioned over the air gaps 210a,b. In some embodiments, both sensing elements 110a,b can be provided as multiple TMR elements arranged in a half bridge or full bridge topology.

Fig. 2B is a side view showing a portion of the leakage current sensor and a magnetic flux concentrator assembly 200 of Fig. 2. The location of magnetic field sensing elements 212a,b within sensor IC package 203 are shown for reference. Conductors 208a,b are not shown in Fig. 2B.

Fig. 2C is another side view showing a portion of the leakage current sensor and a magnetic flux concentrator assembly 200 of Fig. 2. Conductors 208a,b are not shown in Fig. 2C.

Figs. 2, 2A, 2B, and 2C include reference scales, which are provided merely as examples and not intended to be limiting.

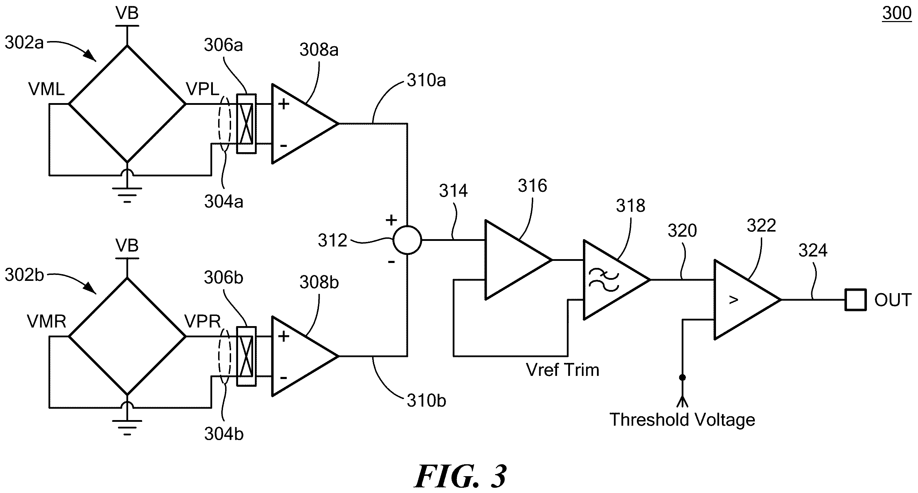

Fig. 3 shows an example of a leakage current sensor circuit 300, according to some embodiments. Circuit 300 may be used in conjunction with a magnetic flux concentrator that generates a field for in-plane differential in-plan sensing. For example, circuit 300 may be implemented within sensor 202 of Fig. 2.

Circuit 300 includes a first magnetic field sensing element 302a and a second magnetic field sensing element 302b that may correspond to, for example, sensing elements 110a,b in Fig. 1A or sensing elements 212a,b in Fig. 2B. As shown, sensing elements 302a,b may be provided as full bridge elements, such as full bridge TMR elements. Referring to first sensing element 302a, terminal VP can be connected to a bias (or "trim") voltage, terminals VML and VPL can provide a first sensing signal 304a, and the fourth terminal can be connected to a reference potential (e.g., ground). Similarly, for second sensing element 302b, terminal VP can be connected to the bias voltage, terminals VMR and VPR can provide a second sensing signal 304b, and the fourth terminal can be connected to the reference potential. Both sensing signals 304a,b can have a magnitude (e.g., voltage level) responsive to magnetic field in the plane of the respective sensing element 302a,b.

Sensing signals 304a,b can have a non-zero voltage when there is a current difference between two inductors of interest, such as conductors 104a,b in Fig. 2. In some cases, one of the sensing signals can have a positive voltage and the other can have a negative voltage in response to a current difference.

Circuit 300 further includes a first swapping circuit 306a having a differential input connected to receive first sensing signal 304a and a differential output connected to a first chopped amplifier 310a, and a second swapping circuit 306b having a differential input connected to receive second sensing signal 304b and a differential output connected to a second chopped amplifier 310b. Swapping circuits 306a,b can connect different ones their differential inputs to different ones of their differential outputs, thereby changing the polarity of the signals generated by sensing elements 302a,b (i.e., swapping the bridge polarities). In some cases, swapping circuits 306a,b may operate such that one signal is positive (>0V) and the other is negative (<0V). The signals can then be combined (e.g., summed together) to detect a difference a current difference across the two conductors.

Circuit 300 further includes an element 312 to receive the two amplified signals 310a,b and to generate a combined sensing signal 314 having a magnitude (e.g., voltage) equal to a sum of the magnitudes of amplified signals 310a,b. By operation of swapping circuits 306a,b, combined sensing signal 314 can have a magnitude corresponding to a difference between the two sensing signals 304a,b. Thus, element 312 can be said to compute either a sum or a difference of the two amplified sensing signals.

Circuit 300 may also include one or more blocks to condition the combined sensing signal 314 prior to leakage detection. For example, as shown, circuit 300 can include an amplification stage 316 and a filtering stage 318.

A resulting conditioned signal 320 may be used for leak detection. For example, as shown, circuit 300 can include a comparator 322 that takes, as input, conditioned signal 320 and a threshold value (e.g., a threshold voltage) and generates an output signal 324 responsive to a comparison of the two inputs. For example, output signal 324 can have a first state (e.g., a non-zero voltage or "high" value) when a magnitude (e.g., voltage) of conditioned signal 320 is greater than the threshold value, and can have a second state (e.g., a zero voltage or "low" value) when the magnitude of conditioned signal 320 is less than or equal to the threshold value. The comparator threshold value may set, or fixed, in the factory at the time of manufacture, or by external means, e.g., programming, thereafter. In some cases, the threshold value may be a selected to detect a dc leakage current in the range of 5 to 6mA or an ac leakage current of about 30mA.

Thus, when circuit 300 is implemented within a leakage current sensor (e.g., sensor 202 of Fig. 2), output signal 324 can indicate whether there is a difference in current between the two conductors 208a,b, such as a short caused by an exposed wire touches a metal housing. In some embodiments, output signal 324 may be provided at an output of the leakage current sensor (e.g., a package lead or pin). An external circuit, device, or system (e.g., a GFI circuit, a control system, etc.) may use the sensor output to take protective action in response to a detected current leak, for example by disconnecting a source of the current.

Fig. 4 demonstrates how air gap design parameters in Fig. 1B can be varied to achieve a desired concentrator coupling factor. A graph 400 has a horizontal axis corresponding to the Ygap parameter (mm) and a vertical axis corresponding to coupling factor (G/A). Four curves 402a-d are plotted, representing different values of X1+X3. In this example, it is assumed that Xgap=2mm, W=1mm, and TMR_dist=1.5mm. As shown, the coupling factor can be increased by decreasing Ygap and by increasing X1+X3. Graph 400 illustrates that disclosed planar-field concentrator structures and designs can achieve coupling factors significantly higher than can be achieved with perpendicular-field concentrators (2X higher).

While embodiments of the present disclosure are described as using TMR sensing elements, it will be appreciated that the general concepts and structures described herein may be used with other types of in-plane sensing elements, including but not limited to vertical Hall elements. Moreover, the magnetic flex concentrator structures and design methodologies disclosed herein are limited to use in current leakage sensing applications.

As used in the claims or elsewhere herein, the term "comprising" does not exclude other elements or steps, and the indefinite article "a" or "an" does not exclude a plurality.

While electronic circuits shown in figures herein may be shown in the form of analog blocks or digital blocks, it will be understood that the analog blocks can be replaced by digital blocks that perform the same or similar functions and the digital blocks can be replaced by analog blocks that perform the same or similar functions. Analog-to-digital or digital-to-analog conversions may not be explicitly shown in the figures but should be understood.

As used herein, the terms "processor" and "controller" are used to describe electronic circuitry that performs a function, an operation, or a sequence of operations. The function, operation, or sequence of operations can be hard coded into the electronic circuit or soft coded by way of instructions held in a memory device. The function, operation, or sequence of operations can be performed using digital values or using analog signals. In some embodiments, the processor or controller can be embodied in an application specific integrated circuit (ASIC), which can be an analog ASIC or a digital ASIC, in a microprocessor with associated program memory, in a digital signal processor (DSP), and/or in a discrete electronic circuit, which can be analog or digital. A processor or controller can include internal processors or modules that perform portions of the function, operation, or sequence of operations. Similarly, a module can include internal processors or internal modules that perform portions of the function, operation, or sequence of operations of the module. A single processor or other unit may fulfill the functions of several means recited in the claims.

Various embodiments of the concepts systems and techniques are described herein with reference to the related drawings. Alternative embodiments can be devised without departing from the scope of the described concepts. It is noted that various connections and positional relationships (e.g., over, below, adjacent, etc.) are set forth between elements in the claims, detailed description, and drawings. These connections and/or positional relationships, unless specified otherwise, can be direct or indirect, and the claimed inventions are not intended to be limiting in this respect. Accordingly, a coupling/connection of entities can refer to either a direct or an indirect coupling/connection, and a positional relationship between entities can be a direct or indirect positional relationship. As an example of an indirect positional relationship, references in the present description to element or structure A coupled/connected to element or structure B include situations in which one or more intermediate elements or structures (e.g., element C) is provided between elements A and B regardless of whether the characteristics and functionalities of elements A and/or B are substantially changed by the intermediate element(s).

Furthermore, it should be appreciated that relative, directional or reference terms (e.g. such as "above," "below," "left," "right," "top," "bottom," "vertical," "horizontal," "front," "back," "rearward," "forward," etc.) and derivatives thereof are used only to promote clarity in the description of the figures. Such terms are not intended as, and should not be construed as, limiting. Such terms may simply be used to facilitate discussion of the drawings and may be used, where applicable, to promote clarity of description when dealing with relative relationships, particularly with respect to the illustrated embodiments. Such terms are not, however, intended to imply absolute relationships, positions, and/or orientations. For example, with respect to an object or structure, an "upper" or "top" surface can become a "lower" or "bottom" surface simply by turning the object over. Nevertheless, it is still the same surface and the object remains the same.

The terms "disposed over," "overlying," "atop," "on top," "positioned on" or "positioned atop" mean that a first element, such as a first structure, is present on a second element, such as a second structure, where intervening elements or structures (such as an interface structure) may or may not be present between the first element and the second element. The term "direct contact" means that a first element, such as a first structure, and a second element, such as a second structure, are connected without any intermediary elements or structures between the interface of the two elements. The term "connection" can include an indirect connection and a direct connection.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

The terms "approximately" and "about" may be used to mean within ±20% of a target value in some embodiments, within ±10% of a target value in some embodiments, within ±5% of a target value in some embodiments, and yet within ±2% of a target value in some embodiments. The terms "approximately" and "about" may include the target value. The term "substantially equal" may be used to refer to values that are within ±20% of one another in some embodiments, within ±10% of one another in some embodiments, within ±5% of one another in some embodiments, and yet within ±2% of one another in some embodiments.

The term "substantially" may be used to refer to values that are within ±20% of a comparative measure in some embodiments, within ±10% in some embodiments, within ±5% in some embodiments, and yet within ±2% in some embodiments. For example, a first direction that is "substantially" perpendicular to a second direction may refer to a first direction that is within ±20% of making a 90° angle with the second direction in some embodiments, within ±10% of making a 90° angle with the second direction in some embodiments, within ±5% of making a 90° angle with the second direction in some embodiments, and yet within ±2% of making a 90° angle with the second direction in some embodiments.

In the foregoing detailed description, various features are grouped together in one or more individual embodiments for the purpose of streamlining the disclosure. This method of disclosure is not to be interpreted as reflecting an intention that each claim requires more features than are expressly recited therein. Rather, inventive aspects may lie in less than all features of each disclosed embodiment.

References in the disclosure to "one embodiment," "an embodiment," "some embodiments," or variants of such phrases indicate that the embodiment(s) described can include a particular feature, structure, or characteristic, but every embodiment can include the particular feature, structure, or characteristic. Moreover, such phrases are not necessarily referring to the same embodiment(s). Further, when a particular feature, structure, or characteristic is described in connection knowledge of one skilled in the art to affect such feature, structure, or characteristic in connection with other embodiments whether or not explicitly described.

The disclosed subject matter is not limited in its application to the details of construction and to the arrangements of the components set forth in the detailed description or illustrated in the drawings. The disclosed subject matter is capable of other embodiments and of being practiced and carried out in various ways. As such, those skilled in the art will appreciate that the conception, upon which this disclosure is based, may readily be utilized as a basis for the designing of other structures, methods, and systems for carrying out the several purposes of the disclosed subject matter. Therefore, the claims should be regarded as including such equivalent constructions insofar as they do not depart from the spirit and scope of the disclosed subject matter.

Although the disclosed subject matter has been described and illustrated in the foregoing exemplary embodiments, it is understood that the present disclosure has been made only by way of example, and that numerous changes in the details of implementation of the disclosed subject matter may be made without departing from the spirit and scope of the disclosed subject matter.

Other variations to the disclosed embodiments can be understood and effected by those skilled in the art in practicing the claimed invention, from a study of the drawings, the disclosure, and the appended claims.

The mere fact that certain measures are recited in mutually different dependent claims does not indicate that a combination of these measures cannot be used to obtain an advantage.

Any reference signs in the claims should not be construed as limiting the scope.

All publications and references cited herein are expressly incorporated herein by reference in their entirety.

## Claims

1. A magnetic flux concentrator comprising:
a ferromagnetic material having a loop shape interrupted by an air gap region and forming a central opening,
wherein the air gap region includes a first side having at least two protrusions and a second side having at least one protrusion interleaved with, and not in mechanical contact with, the protrusions of the first side.

2. The magnetic flux concentrator of claim 1 wherein the loop shape lies within a plane, wherein in response to a difference in current between two conductors positioned within the central opening, the concentrator generates a differential magnetic field within the plane.

3. The magnetic flux concentrator of claim 2 wherein, in response to the difference in current between the two conductors positioned within the central opening, the concentrator generates a substantially symmetrical field along an axis perpendicular to the plane.

4. The magnetic flux concentrator of claim 1 wherein the protrusions on the first side of the air gap region and the protrusion of the second side of the air gap region extend along a common axis.

5. The magnetic flux concentrator of claim 4 wherein the air gap region includes at least:
a first air gap extending along the common axis from the first side of the air gap region to the protrusion of the second side of the air gap region;
a second air gap extending along an axis perpendicular to the common axis from a first one of the protrusions of the first side of the air gap region and the protrusion of the second side of the air gap region; and
a third air gap extending along the perpendicular axis from a second one of the protrusions of the first side of the air gap region and the protrusion of the second side of the air gap region.

6. The magnetic flux concentrator of claim 5 wherein the first air gap has a length (Xgap) and the second and third air gaps both have a length (Ygap), wherein Xgap is substantially greater than Ygap.

7. The magnetic flux concentrator of claim 6 wherein Ygap is in a range of 0.2mm to 2mm.

8. The magnetic flux concentrator of claim 4 wherein the protrusion of the second side extends along the common axis into a U-shaped opening formed by the protrusions of the first side by a distance in a range of 0.5mm to 2.0mm.

9. The magnetic flux concentrator of claim 1 wherein the loop shape is tapered.

10. The magnetic flux concentrator of claim 1 wherein the loop shape is substantially an annulus.

11. A system comprising:
first and second magnetic field sensing elements both supported by a substrate and both having an axis of maximum sensitivity parallel to the substrate; and
a magnetic flux concentrator having an air gap region comprising at least a first air gap positioned above or below the first magnetic field sensing element and a second air gap positioned above or below the second magnetic field sensing element, the magnetic flux concentrator configured to generate a differential magnetic field about the first and second magnetic field sensing elements and parallel to the substrate.

12. The system of claim 11 wherein the magnetic flux concentrator has a loop shape interrupted by the air gap region and forming a central opening.

13. The system of claim 12 where the differential magnetic field is generated in response to a difference in current between two conductors positioned within the central opening.

14. The system of claim 13 further comprising circuitry configured to:
receive a first sensing signal generated by the first magnetic field sensing element;
receive a second sensing signal generated by the second magnetic field sensing element; and
detect the difference in current using the first and second sensing signals.

15. The system of claim 14 wherein the circuitry includes at least one of:
a first swapping to change a polarity of the first sensing signal; and
a second swapping to change a polarity of the second sensing signal.

16. The system of claim 14 wherein the circuitry includes:
an element to generate a combined sensing signal as a sum or a difference of the first and second sensing signals; and
a comparator to detect the difference in current using the combined sensing signal.

17. The system of claim 11 wherein the first and second magnetic field sensing elements both include four tunneling magnetoresistance (TMR) elements arranged in a full bridge.

18. The system of claim 11 wherein the substrate is provided within an integrated circuit (IC) package affixed to a surface of a printed circuit board (PCB), wherein the magnetic flux concentrator is arranged parallel to the surface of the PCB.

19. The system of claim 18 wherein the magnetic flux concentrator is at least partially encased in a housing affixed to the PCB.
